## Europäisches Patentamt
## European Patent Office
## Office européen des brevets

(11) Veröffentlichungsnummer: **0 281 770 B1**

## EUROPÄISCHE PATENTSCHRIFT

(45) Veröffentlichungstag der Patentschrift: **22.01.92**

(51) Int. Cl.5: **G03F 7/18**

(21) Anmeldenummer: **88101755.2**

(22) Anmeldetag: **06.02.88**

(54) **Verfahren zum Beschichten von Formzylindern oder Formzylinder-Hülsen mit einer durchgehenden lichtempfindlichen Aufzeichnungsschicht.**

(30) Priorität: **14.02.87 DE 3704694**

(43) Veröffentlichungstag der Anmeldung:
**14.09.88 Patentblatt 88/37**

(45) Bekanntmachung des Hinweises auf die Patenterteilung:
**22.01.92 Patentblatt 92/04**

(84) Benannte Vertragsstaaten:
**BE DE FR GB IT NL**

(56) Entgegenhaltungen:
EP-A- 0 104 954     EP-A- 0 168 636
DE-A- 609 659       FR-A- 1 345 015
FR-A- 2 391 072     GB-A- 545 942
NL-A- 8 501 052

PATENT ABSTRACTS OF JAPAN, Band 7, Nr. 286 (P-244)[1431], 21. Dezember 1983; & JP-A-58 160 956 (TORAY K.K.) 24-09-1983

IBM TECHNICAL DISCLOSURE BULLETIN, Band 15, Nr. 1, Juni 1972, Seite 46, New York, US; R.S. HORST et al.: "Resist process"

PATENT ABSTRACTS OF JAPAN, Band 6, Nr. 62 (P-111)[940], 21. April 1982; & JP-A-57 4047

(RICOH K.K.) 09-01-1982

IBM TECHNICAL DISCLOSURE BULLETIN, Band 15, Nr. 2, Juli 1972, Seite 654, New York, US; P. BAKOS et al.: "Undercoat to prevent underplating in electrolytic processing"

(73) Patentinhaber: **BASF Aktiengesellschaft
Carl-Bosch-Strasse 38
W-6700 Ludwigshafen(DE)**

(72) Erfinder: **Koch, Horst, Dr.
Tiefenthaler Strasse 47
W-6718 Gruenstadt(DE)**
Erfinder: **Bach, Helmut, Dr.
Dahlienstrasse 7
W-6704 Mutterstadt(DE)**
Erfinder: **Jaeckel, Klaus-Peter, Dr.
Kopernikusstrasse 8
W-6700 Ludwigshafen(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 281 770 B1

**Beschreibung**

Die Erfindung betrifft ein Verfahren zum Beschichten von Formzylindern oder Formzylinder-Hülsen mit einer durchgehenden, endlosen, lichtempfindlichen, insbesondere photopolymerisierbaren, Aufzeichnungsschicht, wobei die so beschichteten Formzylinder bzw. Formzylinder-Hülsen für die Herstellung von Rotationsdruckformen geeignet sein sollen.

Verfahren zum Beschichten, insbesondere endlosen Beschichten, von Formzylindern oder Formzylinder-Hülsen ("sleeves") mit einer lichtempfindlichen, insbesondere photopolymerisierbaren, Aufzeichnungsschicht, sind an sich bekannt. Neben direkten Methoden zur Herstellung von Endlosbeschichtungen, wie beispielsweise der Lösungsbeschichtung oder Ringextrusion, sind hierfür insbesondere Verfahren beschrieben worden, bei denen man eine vorgefertigte, feste thermoplastisch verarbeitbare lichtempfindliche Schicht um einen Formzylinder oder eine Formzylinder-Hülse herumwickelt und die dabei zusammenstoßenden Kanten der End- und/oder Seitenbereiche der lichtempfindlichen Schicht unter Einwirkung von Wärme und/oder Druck und Herstellen einer durchgehend verbundenen, nahtlosen lichtempfindlichen Schicht miteinander verschweißt. Zum einschlägigen Stand der Technik sei z.B. auf die DE-B-27 22 896, DE-A-28 42 440, DE-A-28 44 426, DE-A-29 11 908, DE-A-31 25 564, EP-A-40 893, EP-A-43 623 sowie EP-A-111 371 verwiesen. Aus den so mit einer durchgehenden lichtempfindlichen Aufzeichnungsschicht endlos beschichteten Formzylindern oder Formzylinder-Hülsen lassen sich durch bildmäßiges Belichten mit aktinischem Licht und Entwickeln Druckzylinder bzw. Druckzylinder-Hülsen für den Rotationsdruck herstellen, die beispielsweise für den Flexodruck oder Tiefdruck, insbesondere auch für den Rollendruck von Endlosmustern, geeignet sind. Nachteilig bei den bekannten Verfahrensweisen ist, daß die an sich bekannte und übliche rückseitige Vorbelichtung der lichtempfindlichen Aufzeichnungsschicht, wie sie z.B. in der US-A 3 210 187, US-A 3 259 499 oder US-A 3 408 191 beschrieben ist, nicht möglich ist.

Die übliche rückseitige vollflächige Vorbelichtung von lichtempfindlichen Aufzeichnungsschichten führt bei negativ arbeitenden Materialien bekanntlich zu einer Photovernetzung des unteren Bereichs der Aufzeichnungsschicht, bevor durch eine vorderseitige bildmäßige Hauptbelichtung eine bildmäßige Vernetzung in den belichteten Teilbereichen der unvernetzten Restschicht erfolgt, die nach Entwickeln, z.B. Auswaschen der unbelichteten Anteile der bildmäßig belichteten Restschicht, die zum Druck bestimmte Reliefstruktur entstehen läßt. Die rückseitige Vorbelichtung erlaubt auch, auf Grund der dünneren unbelichteten, aber für die Reliefstruktur hinreichenden Schichtstärke der verbleibenden unvernetzten Aufzeichnungsschicht die Zeit für die bildmäßige Hauptbelichtung signifikant zu verkürzen und bei befriedigenden Zwischentiefen der Reliefstruktur eine gute Versockelung auch feiner Reliefelemente des entwickelten Druckreliefs zu erzielen. Wird nicht rückseitig vorbelichtet, so müssen zur ausreichenden Versockelung feiner Reliefelemente längere Zeiten für die bildmäßige Hauptbelichtung angewendet werden, was leicht zu einem Zugehen der Zwischentiefen bei feinen negativen Bildelementen führt.

Während eine rückseitige vollflächige Vorbelichtung der lichtempfindlichen Aufzeichnungsschicht bei der Endlosbeschichtung von Formzylindern oder Formzylinder-Hülsen durch Lösungsmittelbeschichtung oder Ringextrusion überhaupt nicht möglich ist, führt sie bei Aufbringen einer vorgefertigten, festen lichtempfindlichen Aufzeichnungsschicht auf einen Formzylinder bzw. eine Formzylinder-Hülse zu Schwierigkeiten. An den Stoßkanten der rückseitig vollflächig vorbelichteten Aufzeichnungsschicht läßt sich das Schichtmaterial nicht mehr zufriedenstellend verschweißen, wie es zur Herstellung endlos beschichteter Formzylinder bzw. Formzylinder-Hülsen zweckmäßig und notwendig ist, da bekanntlich nur eine unvernetzte, nicht aber eine belichtete, vernetzte Polymerschicht sich einwandfrei verschweißen läßt. Ferner zeigt eine vernetzte Polymerschicht auf dem kontaktierten Formzylinder bzw. der kontaktierten Formzylinder-Hülse eine deutlich schlechtere Haftung. Auf Grund der nicht-möglichen rückseitigen Vorbelichtung bei mit endlosen lichtempfindlichen Aufzeichnungsschichten versehenen Formzylindern bzw. Formzylinder-Hülsen oder bei vorgefertigten, lichtempfindlichen Aufzeichnungsschichten vor dem Aufbringen auf Formzylinder bzw. Formzylinder-Hülsen lassen sich mit den Rotationsdruckformen, die aus solchen mit lichtempfindlichen Aufzeichnungsschichten beschichteten Formzylindern oder Formzylinder-Hülsen hergestellt worden sind, daher meist nicht die gleichen niedrigen Tonwerte beim Druck erzielen wie mit entsprechenden ebenen lichtempfindlichen Druckplatten, die eine Rückseiten-Vorbelichtung zulassen.

In der FR-A-23 91 072 bzw. DE-A-27 22 896 ist ein spezielles Verfahren zum Beschichten eines Formzylinders oder einer Formzylinder-Hülse mit einer vorgefertigten, thermoplastisch verarbeitbaren, photohärtbaren Aufzeichnungsschicht beschrieben. Zum Beschichten wird hierbei die Lichtempfindliche Aufzeichnungsschicht in einer einzigen Lage mit Hilfe von doppelseitigen Klebebändern aufgebracht.

Aus der JP-A-58/160 956 geht ein Herstellungsverfahren für photopolymere Reliefdruckplatten hervor, bei dem eine photogehärtete, nicht mehr lichtempfindliche Harzschicht und eine nicht photogehärtete, Lichtempfindliche Harzschicht aufeinander laminiert werden. Hierbei handelt es sich um die Herstellung von

2

ebenen Platten und nicht um ein Verfahren zum Beschichten von Formzylindern oder Formzylinder-Hülsen.

GB-A-545 942 beschreibt ein Herstellungsverfahren für eine flache oder zylindrische Druckform, bei dem zwischen einem Träger und einer Schicht aus einer photographischen Gelatineemulsion, die ein lichtempfindliches Silberhalogenid enthält, eine spezielle Substratschicht aufgebracht wird. Die Substratschicht wird hierbei durch Belichten und Auswaschen mit kaltem Wasser derart vorbehandelt, daß sie beim Aufbringen der lichtempfindlichen Silberhalogenid-Schicht nicht mehr lichtempfindlich, d.h. zu Photoreaktionen fähig, ist.

Aufgabe der vorliegenden Erfindung war es, unter Vermeidung der Nachteile des Standes der Technik ein Verfahren aufzuzeigen, welches zu mit einer lichtempfindlichen, photopolymerisierbaren Aufzeichnungsschicht endlos beschichteten Formzylindern oder Formzylinder-Hülsen führt, die sich bei Anwendung kürzerer Belichtungszeiten zur Herstellung von Rotationsdruckformen mit gut ausgeprägter Reliefstruktur auch bei feinen Reliefbestandteilen und negativen Bildelementen eignen.

In der älteren europäischen Patentanmeldung 87 101 295.1 (EP-A-231 902) wurde hierzu vorgeschlagen, auf den Formzylinder oder die Formzylinder-Hülse eine photoempfindliche Aufzeichnungsschicht aufzubringen, die zuvor rückseitig rasterartig vorbelichtet worden ist, so daß in der rückseitigen bzw. unteren Schichtebene nur diskrete Volumenelemente bzw. Anteile durch die Vorbelichtung photovernetzt bzw. photopolymerisiert wurden und dazwischen in der rückseitigen Schichtebene noch unvernetztes bzw. polymerisierbares Schichtmaterial verbleibt.

Es wurde nun gefunden, daß man die gestellte Aufgabe auch lösen und die vorbeschriebenen Nachteile vermeiden kann, wenn man die lichtempfindliche, photopolymerisierbare Aufzeichnungsschicht in mehreren Lagen nacheinander auf den Formzylinder bzw. die Formzylinder-Hülse aufbringt, wobei man in einem ersten Schritt den Formzylinder bzw. die Formzylinder-Hülse mit einer ersten durchgehenden Lage einer lichtempfindlichen, photopolymerisierbaren Aufzeichnungsschicht beschichtet, diese erste Lage dann vollflächig mit aktinischem Licht derart vorbelichtet, daß sie auch nach dieser vollflächigen Belichtung noch zu weiteren Photoreaktionen befähigt ist, und darauf auf diese vorbelichtete erste Lage mindestens eine weitere durchgehende Lage der gleichen oder einer anderen lichtempfindlichen, photopolymerisierbaren Aufzeichnungsschicht blasenfrei aufbringt.

Gegenstand der Erfindung ist dementsprechend ein Verfahren zum Beschichten eines Formzylinders oder einer Formzylinder-Hülse mit einer durchgehenden, endlosen lichtempfindlichen, photopolymerisierbaren Aufzeichnungsschicht, welches dadurch gekennzeichnet ist, daß man den Formzylinder bzw. die Formzylinder-Hülse zunächst mit einer ersten durchgehenden Lage einer lichtempfindlichen, photopolymerisierbaren Aufzeichnungsschicht beschichtet, diese erste Lage anschließend vollflächig mit aktinischem Licht derart vorbelichtet, daß sie auch nach dieser vollflächigen Belichtung noch zu weiteren Photoreaktionen befähigt ist, und darauf auf diese vorbelichtete erste Lage mindestens eine weitere durchgehende Lage der gleichen oder einer anderen lichtempfindlichen, photopolymerisierbaren Aufzeichnungsschicht blasenfrei aufbringt.

Gegenstand der Erfindung ist weiterhin die Verwendung der so hergestellten, mit einer lichtempfindlichen, photopolymerisierbaren Aufzeichnungsschicht endlos beschichteten Formzylinder bzw. Formzylinder-Hülsen zur Herstellung von Rotationsdruckformen, insbesondere für den Flexodruck oder auch für den Tiefdruck.

Das erfindungsgemäße Verfahren ist nicht nur auf das Beschichten von Formzylindern bzw. Formzylinder-Hülsen durch Aufbringen einer vorgefertigten, festen lichtempfindlichen, photopolymerisierbaren Aufzeichnungsschicht beschränkt, sondern breit und allgemein anwendbar. Mit den aus den Verfahrensprodukten in an sich bekannter Weise hergestellten Druckformen lassen sich im Rotationsdruck hochqualitative Drucke auch niedriger Tonwerte in hohen Auflagen herstellen.

Für den Einsatz in dem erfindungsgemäßen Verfahren sind alle an sich bekannten und beschriebenen, positiv oder negativ arbeitenden, lichtempfindlichen, photopolymerisierbaren Aufzeichnungsschichten geeignet, die sich durch bildmäßiges Belichten mit aktinischem Licht und Entwickeln zu Druckformen verarbeiten lassen. Geeignete photopolymerisierbare Aufzeichnungsschichten enthalten im allgemeinen mindestens ein polymeres Bindemittel, wie z.B. lösliche Polyamide, teilverseifte Polyvinylacetate, gegebenenfalls weichgemachte Polyvinylalkohole oder Polyvinlalkohol-Derivate, Polyurethane, Dienpolymerisate, wie z.B. Blockcopolymerisate aus Styrol, Butadien und/oder Isopren oder Butadien/Acrylnitril-Copolymerisate, mindestens eine niedermolekulare, ethylenisch ungesättigte photopolymerisierbare Verbindung, wie z.B. die bekannten, (Meth)acrylat- oder (Meth]acrylamido-Gruppen enthaltenden Monomeren, mindestens einen Photopolymerisationsinitiator, wie z.B. Benzoinether, Benzilmonoketale oder Acylphosphinoxide, sowie übliche Zusatz- und/oder Hilfsstoffe, wie z.B. thermische Polymerisationsinhibitoren, Farbstoffe, Pigmente, Füllstoffe, Weichmacher, Verlaufshilfsmittel, sensitometrische Regler, etc.. Insbesondere kommen für das erfindungsgemäße Verfahren die lichtempfindlichen, photopolymerisierbaren Aufzeichnungsschichten in Betracht, wie sie für die Herstellung von Flexodruckformen oder Tiefdruckformen bekannt und beschrieben sind (vgl. z.B. DE-A-22 15 090, DE-A-29 02 412, EP-B-27 612, DE-A-20 61 287, EP-A-70 510, EP-A-70 511). Vorzugsweise werden in dem erfindungsgemäßen Verfahren feste lichtempfindliche, photopolymerisierbare Aufzeichnungsschichten eingesetzt, die thermoplastisch verarbeitbar und verformbar sind. Hierzu gehören insbesondere solche für die Herstellung von Druck- und Reliefformen an sich bekannten, festen, polymeren lichtempfindlichen, photopolymerisierbaren Aufzeichnungsschichten, die bei Erwärmung erweichen und unter Druck verfließen bzw. verkleben.

Als Formzylinder bzw. Formzylinder-Hülse kommen für das erfindungsgemäße Verfahren vor allem die Zylinder und zylindrischen Hülsen, einschließlich der konisch zulaufenden Formzylinder-Hülsen, in Betracht, wie sie bekanntermaßen zum endlosen Beschichten mit lichtempfindlichen Aufzeichnungsschichten zur Herstellung von zylindrischen Druckformen für den Rotationsdruck verwendet werden. Während die Formzylinder üblicherweise aus Metall bestehen, können die Formzylinder-Hülsen aus Metall, Kunststoffen, glasfaserverstärkten Kunststoffen oder dgl. gebildet sein. Zur Erzielung einer guten Haftung zwischen Formzylinder bzw. Formzylinder-Hülse einerseits und lichtempfindlicher, photopolymerisierbarer Aufzeichnungsschicht andererseits werden vorteilhafterweise solche Formzylinder bzw. Formzylinder-Hülsen verwendet, deren Oberfläche aufgerauht oder mit einer haftvermittelnden Schicht versehen ist.

Erfindungsgemäß bringt man in einem ersten Schritt auf den, gegebenenfalls vorbehandelten, Formzylinder bzw. die, gegebenenfalls vorbehandelte, Formzylinder-Hülse eine erste durchgehende, d.h. endlose Lage einer lichtempfindlichen, photopolymerisierbaren Aufzeichnungsschicht der in Rede stehenden Art auf. Dieses kann beispielsweise durch Lösungsbeschichtung mittels der bekannten Ringbeschichtungsanlagen, Verdampfen des Lösungsmittels sowie gegebenenfalls Trocknen der Schicht oder durch Schmelzbeschichtung, beispielsweise mittels der bekannten Ringextrusionsbeschichtungsanlagen, erfolgen. In aller Regel geht man jedoch zum Aufbringen der ersten Lage der lichtempfindlichen, photopolymerisierbaren Aufzeichnungsschicht auf den Formzylinder bzw. die Formzylinder-Hülse von einer vorgefertigten, festen, vorzugsweise trägerfreien, thermoplastisch verarbeitbaren lichtempfindlichen, photopolymerisierbaren Aufzeichnungsschicht aus. Diese vorgefertigte, feste, thermoplastisch verarbeitbare lichtempfindliche, photopolymerisierbare Aufzeichnungsschicht kann nach den bekannten, beispielsweise im vorstehend zitierten Stand der Technik beschriebenen Arbeitstechniken in einer ersten Lage auf dem Formzylinder oder die Formzylinder-Hülse haftfest und unter Ausbildung einer durchgehenden, endlosen Lage aus der lichtempfindlichen, photopolymerisierbaren Aufzeichnungsschicht aufgebracht werden. Hierzu wird im allgemeinen die maßgerecht und passend auf den Zylinderumfang zugeschnittene, vorgefertigte lichtempfindliche, photopolymerisierbare Aufzeichnungsschicht so auf die gegebenenfalls vorbehandelten, vorbeschichteten oder auch mit einem textilen Gewirke überzogenen Formzylinder bzw. Formzylinder-Hülsen aufgebracht und fixiert, daß nach der Umwicklung des Formzylinders bzw. der Formzylinder-Hülse mit einer Lage der lichtempfindlichen, photopolymerisierbaren Aufzeichnungsschicht deren Schnittkanten aneinanderstoßen, worauf die Stoßkanten der so aufgebrachten lichtempfindlichen, photopolymerisierbaren Aufzeichnungsschicht bei erhöhter Temperatur, vorzugsweise im Bereich von 40 bis 200 $^{\circ}$C, und insbesondere im Bereich von 80 bis 150 $^{\circ}$C, unter gleichzeitiger oder nachträglicher Einwirkung von Druck miteinander verschmolzen werden. Das Erzeugen des Druckes geschieht dabei vorzugsweise durch Einwirkung eines Vakuums zwischen Formzylinder bzw. Formzylinder-Hülse und lichtempfindlicher, photopolymerisierbarer Aufzeichnungsschicht bzw. einer sie abdeckenden Kunststoff-Folie oder Schrumpf-Folie nach den aus dem vorstehend zitierten Stand der Technik bekannten Verfahrensweisen. Es können aber auch andere Verfahrenstechniken zum Aufbringen einer vorgefertigten thermoplastischen verarbeitbaren lichtempfindlichen, photopolymerisierbaren Schicht auf einen Formzylinder oder eine Formzylinder-Hülse angewandt werden, sofern hierdurch auf dem Formzylinder bzw. der Formzylinder-Hülse eine erste durchgehend verbundene Lage der lichtempfindlichen, photopolymerisierbaren Aufzeichnungsschicht erzeugt wird, die mit dem Formzylinder bzw. der Formzylinder-Hülse haftfest verbunden ist und deren lichtempfindliche Eigenschaften durch das Aufbringen auf den Formzylinder bzw. die Formzylinder-Hülse nicht beeinträchtigt worden sind.

Im nächsten Schritt des erfindungsgemäßen Verfahrens wird diese erste, durchgehende auf dem Formzylinder bzw. der Formzylinder-Hülse aufgebrachte Lage aus der lichtempfindlichen, photopolymerisierbaren Aufzeichnungsschicht einer vollflächigen Belichtung mit aktinischem Licht unterworfen. Diese vollflächige Belichtung der ersten Lage der lichtempfindlichen Aufzeichnungsschicht kann in Gegenwart oder unter Ausschluß von Luftsauerstoff erfolgen. Die Belichtungszeit für diese vollflächige Belichtung ist so zu wählen, daß diese erste Lage der lichtempfindlichen, photopolymerisierbaren Aufzeichnungsschicht auch nach dieser vollflächigen Belichtung noch zu weiteren Photoreaktionen befähigt ist. Üblicher- und vorteilhafterweise wird diese vollflächige Belichtung der ersten Lage der lichtempfindlichen, photopolymerisierbaren Aufzeichnungsschicht, insbesondere was Dauer und Intensität der Belichtung anbetrifft, in der Art einer Vorbelichtung durchgeführt, d.h. Dauer und Art der vollflächigen Belichtung werden insbesondere entsprechend den Bedingungen für eine sonst übliche rückseitige Vorbelichtung einer entsprechenden lichtempfindlichen, photopolymerisierbaren Aufzeichnungsschicht gewählt. Die Zeiten für die vollflächige Belichtung der ersten Lage der lichtempfindlichen, photopolymerisierbaren Aufzeichnungsschicht liegen typischerweise im Bereich von etwa 5 bis 50 min, in Abhängigkeit von der Art des lichtempfindlichen, photopolymerisierbaren Aufzeichnungsmaterials, der Dicke der ersten Lage der lichtempfindlichen, photopolymerisierbaren Schicht, der verwendeten Lichtquelle, dem gewünschten Eigenschaftsprofil der fertigen Verfahrensprodukte etc..

Erfindungsgemäß wird in einem nächsten Schritt auf die vollflächig vorbelichtete Lage aus der lichtempfindlichen, photopolymerisierbaren Aufzeichnungsschicht mindestens eine weitere durchgehende Lage aus einer unbelichteten lichtempfindlichen, photopolymerisierbaren Aufzeichnungsschicht aufgebracht. Für diese weitere bzw. weiteren Lagen dienen ebenfalls die lichtempfindlichen, photopolymerisierbaren Aufzeichnungsschichten der vorstehend erwähnten Art. Die einzelnen erfindungsgemäß auf den Formzylinder bzw. die Formzylinder-Hülse aufzubringenden Lagen der lichtempfindlichen, photopolymerisierbaren Aufzeichnungsschicht können dabei in ihrer Zusammensetzung - im unbelichteten Zustand - sowohl gleich als auch verschieden sein. Das Aufbringen der weiteren Lage bzw. Lagen aus der lichtempfindlichen, photopolymerisierbaren Aufzeichnungsschicht auf die vorbelichtete erste Lage kann nach den gleichen Techniken erfolgen, nach denen die erste Lage im unbelichteten Zustand auf den Formzylinder bzw. die Formzylinder-Hülse aufgebracht worden ist. D.h., es kommen hierfür die direkten Methoden zur Erzeugung einer Endlosbeschichtung, wie z.B. Lösungsbeschichtung und Ringextrusion in Betracht, wie auch insbesondere die indirekten Methoden, bei denen man von einer Vorgefertigten festen, trägerfreien und im allgemeinen auf den Zylinderumfang zugeschnittenen lichtempfindlichen, photopolymerisierbaren Aufzeichnungsschicht ausgeht, aus der dann nach Aufbringen auf die erste vorbelichtete Lage durch Verbinden bzw. Verschweißen der Stoßkanten eine durchgehende, endlose Lage gebildet wird.

Wichtig ist, daß das Aufbringen der zweiten sowie gegebenenfalls aller weiteren Lagen der lichtempfindlichen, photopolymerisierbaren Aufzeichnungsschicht auf die erste, vorbelichtete Lage blasenfrei und unter Vermeidung von Lufteinschlüssen zwischen den einzelnen Lagen erfolgt. Bei Einsatz von vorgefertigten, festen lichtempfindlichen, photopolymerisierbaren Aufzeichnungsschichten zur Ausbildung der weiteren Lagen kann dieses Erfordernis beispielsweise durch luftverdrängendes Andrücken, z.B. mittels einer Walze, der die weitere Lage bildenden vorgefertigten lichtempfindlichen, photopolymerisierbaren Schicht an die jeweils darunter liegende Lage der lichtempfindlichen, photopolymerisierbaren Aufzeichnungsschicht erfolgen. Um dabei ein gutes Anschmiegen zu gewährleisten und sicherzustellen, kann hierbei die Mitverwendung eines Kaschierhilfsmittels und/oder insbesondere das Arbeiten unter Erwärmen empfehlenswert und hilfreich sein. Ebenso hat es sich zur Vermeidung von Lufteinschlüssen zwischen den einzelnen Lagen als geeignet erwiesen, auf die erste, vorbelichtete Lage beispielsweise zunächst ein Gewebe aufzubringen, bevor man hierauf die zweite Lage aus der unbelichteten lichtempfindlichen, photopolymerisierbaren Aufzeichnungsschicht aufbringt.

Die zweite sowie gegebenenfalls alle weiteren Lagen der unbelichteten lichtempfindlichen, photopolymerisierbaren Aufzeichnungsschichten werden so auf die erste, vorbelichtete Lage aufgebracht, daß ein haftfester Verbund zwischen den einzelnen Lagen entsteht. Hierzu wird im allgemeinen unter Anwendung von Temperatur und/oder Druck gearbeitet. Hierzu kann beispielsweise eine Heißkalandrierung vorgenommen werden, oder es können die mit den Lagen der lichtempfindlichen, photopolymerisierbaren Aufzeichnungsschicht beschichteten Formzylinder bzw. Formzylinder-Hülsen nach Umhüllung mit einer gasdichten Kunststoff-Folie oder Schrumpf-Folien unter Einwirkung von Vakuum erwärmt werden. Es war äußerst überraschend, daß bei dem erfindungsgemäßen Verfahren ohne Anwendung von Haftschichten ein sehr guter und haftfester Verbund zwischen der ersten, vorbelichteten vernetzten Lage der Aufzeichnungsschicht und der darauf aufgebrachten zweiten Lage des unbelichteten lichtempfindlichen, photopolymerisierbaren Aufzeichnungsmaterials entsteht, nachdem die Erfahrung gezeigt hatte, daß sich rückseitig vollflächig vorbelichtete, vorgefertigte lichtempfindliche Aufzeichnungsschichten zum Beschichten von Formzylindern oder Formzylinder-Hülsen mit einer endlosen, lichtempfindlichen Aufzeichnungsschicht nicht oder nur sehr schlecht eignen.

Die Dicke der auf den Formzylinder bzw. die Formzylinder-Hülse aufgebrachten lichtempfindlichen, photopolymerisierbaren Aufzeichnungsschicht insgesamt richtet sich in erster Linie nach dem Verwendungszweck der so beschichteten Formzylinder bzw. Formzylinder-Hülsen. Für die Herstellung von Rotationsdruckformen wird die aus den einzelnen Lagen gebildete lichtempfindliche, photopolymerisierbare Aufzeichnungsschicht ingesamt üblicherweise eine Dicke im Bereich von etwa 200 μm bis zu ca. 6 mm besitzen. Für die Herstellung von Tiefdruckformen sind im allgemeinen dünnere Schichtstärken hinreichend, während für die Herstellung von Rotationsdruckformen für den Flexodruck die aus den einzelnen Lagen gebildete lichtempfindliche, photopolymerisierbare Aufzeichnungsschicht insgesamt in aller Regel eine Schichtdicke im Bereich von etwa 1 bis 6 mm aufweist. Die erfindungsgemäß zunächst aufgebrachte und dann vollflächig vorbelichtete erste Lage der lichtempfindlichen, photopolymerisierbaren Aufzeichnungsschicht macht dabei im allgemeinen etwa 20 bis 80 %, insbesondere etwa 35 bis 70 %, der Dicke der aus den einzelnen Lagen gebildeten gesamten lichtempfindlichen, photopolymerisierbaren Aufzeichnungsschicht aus. Das Verhältnis der Dicke der ersten vorbelichteten Lage zu der Dicke aller weiteren unbelichteten Lagen der lichtempfindlichen, photopolymerisierbaren Aufzeichnungsschicht wird dabei unter anderem mitbestimmt durch die Gesamtdicke der lichtempfindlichen, photopolymerisierbaren Aufzeichnungsschicht, die Art des lichtempfindlichen, photopolymerisierbaren Aufzeichnungsmaterials, die gewünschten Belichtungszeiten und Reliefbildungseigenschaften des erfindungsgemäßen Verfahrensproduktes und dgl. dem Fachmann an sich geläufige und bekannte Einflußgrößen.

Vorzugsweise wird erfindungsgemäß auf die erste durchgehende Lage der lichtempfindlichen, photopolymerisierbaren Aufzeichnungsschicht nach der vollflächigen Belichtung noch eine weitere durchgehende Lage der lichtempfindlichen, photopolymerisierbaren Aufzeichnungsschicht aufgebracht, wobei das lichtempfindliche, photopolymerisierbare Aufzeichnungsmaterial für die beiden Lagen - im unbelichteten Zustand - insbesondere gleich ist.

Die nach dem erfindungsgemäßen Verfahren in mindestens zwei Lagen auf die Formzylinder bzw. Formzylinder-Hülsen aufgebrachte durchgehende lichtempfindliche, photopolymerisierbare Aufzeichnungsschicht kann anschließend noch einer maßgenauen formgebenden Nachbehandlung, beispielsweise durch Abspänen, Abdrehen, Schleifen oder dgl., unterworfen werden. Eine solche formgebende Nachbehandlung dient in erster Linie der Erzeugung einer maßgenauen, gleichmäßigen, nahtlosen äußeren Oberfläche der lichtempfindlichen, photopolymerisierbaren Aufzeichnungsschicht. Sie bewirkt den Ausgleich eventueller geringer Schichtdickenschwankungen und die Erzielung eines exakt zylindrischen Umfangs, was insbesondere bei Verwendung von konisch zulaufenden Formzylinder-Hülsen von Bedeutung ist. Auch kann die Oberfläche der lichtempfindlichen, photopolymerisierbaren Aufzeichnungsschicht abschließend in bekannter Weise geglättet und/oder gegebenenfalls mit einer Deck- oder Schutzschicht versehen werden.

Aus den nach dem erfindungsgemäßen Verfahren mit einer durchgehenden, endlosen lichtempfindlichen, photopolymerisierbaren Aufzeichnungsschicht beschichteten Formzylindern bzw. Formzylinder-Hülsen können in herkömmlicher Weise durch bildmäßige Belichtung mit aktinischem Licht, Entwicklung der Reliefstruktur, beispielsweise durch Auswaschen mit einem geeigneten Entwicklerlösungsmittel, sowie gegebenenfalls Nachbehandlung, beispielsweise durch Trocknen oder Nachbelichten, Druckformen für den Rotationsdruck, insbesondere auch für die Rollenrotation, hergestellt werden. Mit den erfindungsgemäßen Verfahrensprodukten lassen sich dabei, im Vergleich zu den nach herkömmlichen Verfahrensweisen mit einer durchgehenden lichtempfindlichen, photopolymerisierbaren Aufzeichnungsschicht beschichteten Formzylindern bzw. Formzylinder-Hülsen, kürzere Belichtungszeiten und bessere Reliefstrukturen erzielen, was insbesondere für die Wiedergabe feiner Bildelemente und niedriger Tonwerte von großer Bedeutung ist.

Die Erfindung wird durch die nachfolgenden Beispiele näher erläutert.

Beispiel 1

Eine 2,71 mm dicke lichtempfindliche, photopolymerisierbare Aufzeichnungsschicht, die als Bindemittel ein A-B-C-Blockcopolymerisat mit einem Polystyrol-, einem Polyisopren- und einem Styrol/Isopren-Copolymerisat-Block, als Monomere Di(meth)acrylate, Benzildimethylketal als Photoinitiator, einen schwarzen Farbstoff sowie ein handelsübliches $\alpha$-Methyl-styrol-Vinyltoluol-Copolymerisat enthielt und durch Kneten der Komponenten bei 140°C und anschließendes Kalandrieren zwischen zwei Polyesterfolien hergestellt worden war, wurde gemäß Beispiel 1 der EP-A-111 371 auf eine Nickelhülse aufgebracht und die Stoßkanten bei 150°C verschmolzen, so daß eine gleichmäßige, durchgehende Oberfläche entstand. Im Anschluß hieran wurde die lichtempfindliche, photopolymerisierbare Schicht 20 min in Gegenwart von Luftsauerstoff mit einem Flachbelichter belichtet. Auf diese belichtete Schicht wurde anschließend eine 1,17 mm dicke photopolymerisierbare Aufzeichnungsschicht, die die gleiche Zusammensetzung wie die erste Schicht aufwies, aufkaschiert und wurden die Stoßkanten ebenfalls bei 150°C verschmolzen, bis eine gleichmäßige Oberfläche entstand. Durch Tauchen der so mit zwei Lagen einer lichtempfindlichen, photopolymerisierbaren Aufzeichnungsschicht beschichteten Nickelhülse in eine Lösung aus Polyamid wurde eine ca. 5 $\mu$m dicke Schutzschicht auf die Oberfläche der lichtempfindlichen, photopolymerisierbaren Aufzeichnungsschicht aufgetragen, so daß eine klebfreie Oberfläche resultierte. Die beschichtete Nickelhülse wurde anschließend auf einen Formzylinder aufgebracht und die lichtempfindliche, photopolymerisierbare Aufzeichnungsschicht danach 15, 20, 30 bzw. 35 min bildmäßig mit aktinischem Licht belichtet. Nach Auswaschen mit einem
Entwicklerlösungsmittel und Trocknen (60 min bei 60°C) wurde eine Reliefform erhalten, die nach einer Brombehandlung zur Verringerung der Oberflachenklebrigkeit noch 10 min in einem Flachbelichter nachbelichtet wurde. Die Eigenschaften des hergestellten Reliefs sind in der Tabelle aufgeführt. Die so hergestellte Reliefform eignete sich hervorragend als Flexodruckform im Rotationsdruck.

Beispiel 2

Es wurde wie in Beispiel 1 gearbeitet, nur wurde diesmal die erste Lage der lichtempfindlichen, photopolymerisierbaren Aufzeichnungsschicht nach Aufbringen auf die Nickel-Hülse 20 min unter Ausschluß von Luftsauerstoff belichtet. Die erhaltenen Ergebnisse sind ebenfalls in der Tabelle angeführt.

Vergleichsbeispiel

Eine lichtempfindliche, photopolymerisierbare Aufzeichnungsschicht der gleichen Zusammensetzung wie die in Beispiel 1, jedoch mit einer Dicke von 3,88 mm wurde wie in Beispiel 1 der EP-A-111 371 beschrieben auf eine Nickelhülse aufgebracht und die Stoßkanten bei 150 °C verschmolzen, so daß eine gleichmäßige durchgehende Oberfläche entstand. Die so erhaltene beschichtete Hülse wurde, wie in Beispiel 1 beschrieben, mit einer Polyamid-Schutzschicht versehen und zu einer Reliefform verarbeitet. Die erhaltenen Ergebnisse sind ebenfalls der Tabelle zu entnehmen.

Tabelle

| | Bsp. 1 | Bsp. 2 | Vergleichsbsp. |
|---|---|---|---|
| Shore A | 46 | 46 | 44-45 |
| Reliefhöhe | 1200 μm | 1180 μm | 1240 μm |
| Notwendige Belichtungszeit zur Ausbildung eines freistehenden Punktes Ø = 200 μm | 25 Min. | 20 Min. | >35 Min. |
| Notwendige Belichtungszeit zur Ausbildung eines freistehenden Punktes Ø = 400 μm | 15 Min. | 15 Min. | * |
| Notwendige Belichtungszeit eines Rasters mit 2 % Tonwert und 48 Linien/cm | 30 Min. | 35 Min. | Raster-felder nicht auswertbar |
| Notwendige Belichtungszeit eines Rasters mit 3 % Tonwert und 48 Linien/cm | 20 Min. | 25 Min. | |
| Notwendige Belichtungszeit eines Rasters mit 5 % Tonwert und 48 Linien/cm | 15 Min. | 15 Min. | |
| Relieftiefe eines 400 μm Negativpunkts nach 15 Min. Belichtung | 65 | 53 | nicht meßbar |
| Relieftiefe eines 400 μm Negativpunkts nach 20 Min. Belichtung | 57 | 39 | nicht meßbar |
| Relieftiefe eines 400 μm Negativpunkts nach 25 Min. Belichtung | 33 | 55 | nicht meßbar |
| Relieftiefe eines 400 μm Negativpunkts nach 30 Min. Belichtung | 32 | 50 | nicht meßbar |
| Relieftiefe eines 400 μm Negativpunkts nach 35 Min. Belichtung | 32 | 7 | nicht meßbar |

* Begrenzung der Rasterfelder zeigen einen stark ausgeprägten Wulst

## Patentansprüche

1. Verfahren zum Beschichten eines Formzylinders oder einer Formzylinder-Hülse mit einer endlosen, lichtempfindlichen, photopolymerisierbaren Aufzeichnungsschicht, dadurch gekennzeichnet, daß man den Formzylinder bzw. die Formzylinder-Hülse zunächst mit einer ersten durchgehenden Lage einer lichtempfindlichen, photopolymerisierbaren Aufzeichnungsschicht beschichtet, diese erste Lage anschließend vollflächig mit aktinischem Licht derart vorbelichtet, daß sie auch nach dieser vollflächigen Belichtung noch zu weiteren Photoreaktionen befähigt ist, und darauf auf diese vorbelichtete, erste Lage mindestens eine weitere durchgehende Lage der lichtempfindlichen photopolymerisierbaren Aufzeichnungsschicht blasenfrei unter Vermeidung von Lufteinschlüssen zwischen den einzelnen Lagen aufbringt.

2. Verfahren nach Anspruch 1, dadurch gekennzeichnet, daß die auf die vollflächig vorbelichtete erste Lage aufgebrachte zweite Lage der lichtempfindlichen photopolymerisierbaren Aufzeichnungsschicht die gleiche Zusammensetzung wie die erste Lage im unbelichteten Zustand hat.

3. Verfahren nach einem der Ansprüche 1 oder 2, dadurch gekennzeichnet, daß die erste Lage der lichtempfindlichen photopolymerisierbaren Aufzeichnungsschicht etwa 35 bis 70 % der Dicke der gesamten lichtempfindlichen photopolymerisierbaren Aufzeichnungsschicht ausmacht.

4. Verfahren nach einem der Ansprüche 1 bis 3, dadurch gekennzeichnet, daß die einzelnen, durchgehenden Lagen der lichtempfindlichen photopolymerisierbaren Aufzeichnungsschicht durch Aufbringen von vorgefertigten, trägerlosen, festen, thermoplastisch verarbeitbaren Aufzeichnungsschichten unter Verschweißen der Stoßkanten der aufgebrachten Aufzeichnungsschichten und eventuelle formgebende Nachbehandlung hergestellt werden.

5. Verwendung der nach einem der Ansprüche 1 bis 4 hergestellten, mit einer durchgehenden, endlosen, lichtempfindlichen, photopolymerisierbaren Aufzeichnungsschicht beschichteten Formzylinder bzw. Formzylinder-Hülsen zur Herstellung von Rotationsdruckformen, insbesondere für den Flexodruck.

## Claims

1. A process for coating a printing cylinder or a printing cylinder sleeve with a continuous light-sensitive photopolymerizable recording layer, wherein the printing cylinder or the sleeve is first coated with a first jointless stratum of a light-sensitive photopolymerizable recording layer, this first stratum is then preexposed uniformly to actinic light in such a manner that it is still capable of further photoreactions even after this uniform exposure, and thereafter one or more further jointless strata of the light-sensitive photopolymerizable recording layer are applied to this preexposed first stratum, without bubbles and avoiding enclosed air between the individual strata.

2. A process as claimed in claim 1, wherein the second stratum of the light-sensitive photopolymerizable recording layer, which stratum is applied to the uniformly preexposed first stratum, has the same composition as the first stratum in the unexposed state.

3. A process as claimed in claim 1 or 2, wherein the first stratum of the light-sensitive photopolymerizable recording layer accounts for about 35-70% of the thickness of the total light-sensitive photopolymerizable recording layer.

4. A process as claimed in any of claims 1 to 3, wherein the individual, jointless strata of the light-sensitive photopolymerizable recording layer are produced by applying prefabricated, base-free, solid, thermoplastically processible recording layers with welding of the abutting edges of the applied recording layers and possibly a shaping aftertreatment.

5. Use of the printing cylinder or printing cylinder sleeve produced as claimed in any of claims 1 to 4, by coating with a continuous, endless, light-sensitive, photopolymerizable recording layer, for producing rotary printing plates, in particular for flexographic printing.

## Revendications

1. Procédé pour revêtir un cylindre de forme ou une gaine de cylindre de forme d'une couche d'enregistrement photopolymérisable photosensible sans fin,caractérisé en ce que l'on revêt d'abord le cylindre de forme ou la gaine de cylindre de forme, sur toute sa surface, d'une première épaisseur

EP 0 281 770 B1

d'une couche d'enregistrement photopolymérisable photosensible, on soumet ensuite cette première couche, sur toute sa surface, à une exposition préalable à la lumière actinique, en sorte que, après cette exposition sur toute la surface, la couche soit encore apte à de nouvelles photoréactions puis, sur cette première couche exposée au préalable à la lumière, et sur toute la surface, on applique au moins une autre épaisseur de la couche d'enregistrement photopolymérisable photosensible en évitant les inclusions d'air entre les couches individuelles.

2. Procédé selon la revendication 1, caractérisé en ce que la deuxième épaisseur de la couche d'enregistrement photosensible photopolymérisable, appliquée sur la première épaisseur soumise à exposition préalable à la lumière sur toute sa surface, a la même composition que la première couche à l'état non exposé à la lumière.

3. Procédé selon une des revendications 1 ou 2, caractérisé en ce que la première épaisseur de la couche d'enregistrement photosensible photopolymérisable représente environ 35 à 70 % de l'épaisseur de la couche d'enregistrement photosensible photopolymérisable totale.

4. Procédé selon une des revendications 1 à 3, caractérisé en ce que les diverses épaisseurs, recouvrant toute la surface, de couches d'enregistrement photopolymérisables photosensibles sont formées par applications de couches d'enregistrement formées au préalable, sans support, solides, aptes au travail thermoplastique, avec soudure des bords de contact des couches d'enregistrement appliquées et le cas échéant traitement subséquent de façonnage.

5. Utilisation des cylindres de forme ou gaines de cylindres de forme, revêtus sur toute leur surface d'une couche d'enregistrement photosensible photopolymérisable sans fin, obtenus selon l'une des revendications 1 à 4, pour la fabrication de formes d'impression rotative, en particulier pour l'impression flexographique.